# EUROPEAN PATENT APPLICATION

(11) **EP 3 094 164 A1**
(43) Date of publication of application: **16.11.2016**
(21) Application number: 14876463.2
(22) Date of filing: 21.05.2014
(51) Int. Cl.: H05K 5/04

(54) **PANEL FOR SHEET METAL BOX BODY CASE**

(30) Priority: 06.01.2014 CN 201420004921 U
(71) Applicant: ZTE Corporation, Shenzhen, Guangdong 518057 (CN)
(72) Inventor: XIA, Runsheng, Shenzhen Guangdong 518057 (CN); TAO, Shuhua, Shenzhen Guangdong 518057 (CN); LIU, Fenglin, Shenzhen Guangdong 518057 (CN); YAO, Shibin, Shenzhen Guangdong 518057 (CN)
(74) Representative: Quinterno, Giuseppe
(86) International application number: PCT/CN2014/078053
(87) International publication number: WO 2015/100921

(57) **Abstract**

Provided is a panel for a chassis having a sheet metal body. The panel includes: a panel body (20), mated with a chassis having a sheet metal body; elastic connecting components, mounted on the panel body (20); and chassis connecting components, arranged on the chassis having the sheet metal body and mated with the elastic connecting components. Each elastic connecting component includes: a through hole (21), provided on the panel body (20); a base (22), extending in a length direction of the panel body (20), arranged in the through hole (21), and dividing the through hole (21) into two isolated parts which are disposed in a width direction of the plastic panel body (20); and a pair of clamping boards (23, 24), arranged on the base (22) and disposed in the width direction of the panel body (20), wherein the pair of clamping boards (23, 24) extends downwards out of a bottom surface of the panel body (20) from a bottom surface of the base, and outer walls of bottom ends of the pair of clamping boards (23, 24) are provided with flanges (23a, 24a). The panel can be quickly and repeatedly disassembled and assembled, and is applicable to both high-temperature and low-temperature application scenarios.

## Description

### Technical Field

The present disclosure relates to the field of communication devices, and in particular to a panel for a chassis having a sheet metal body.

### Background

Currently, a great number of chassis structures having sheet metal body are applied in the field of communication devices. With the continuous development of society, the original appearance formed by single sheet metal structure cannot satisfy people's visual demands, and a decorative panel emerges as required. Currently, there are mainly two forms of commonly used panel decoration, one of them is to directly coat the sheet metal with a film, while the other one of them is to first put a plastic panel on the sheet metal and then coat the plastic panel with a film. However, the former has inherent defects in attractiveness, and the latter mainly has defects such as assembly difficulty, high-temperature warping, and buckle breakage.

### Summary

The embodiments of the present disclosure solve the problems in the related art and provide a panel for a chassis having a sheet metal body. The panel provided in the embodiments of the present disclosure can be quickly and repeatedly disassembled and assembled and is applicable to both high-temperature and low-temperature application scenarios.

In order to achieve the aim of the embodiments of the present disclosure, the following technical solutions are provided.

A panel for a chassis having a sheet metal body may include: a panel body, mated with a chassis having a sheet metal body; elastic connecting components, mounted on the panel body; and chassis connecting components, arranged on the chassis having the sheet metal body and mated with the elastic connecting components.

In an exemplary embodiment, each elastic connecting component may include: a through hole, provided on the panel body; a base, extending in a length direction of the panel body, arranged in the through hole, and dividing the through hole into two isolated parts which are disposed in a width direction of the plastic panel body; and a pair of clamping boards, arranged on the base and disposed in the width direction of the panel body, wherein the pair of clamping boards extends downwards out of a bottom surface of the panel body from a bottom surface of the base, and outer walls of bottom ends of the pair of clamping boards are provided with flanges.

In an exemplary embodiment, a thickness of the base may be smaller than a thickness of the panel body.

In an exemplary embodiment, a locating column may be arranged in the middle of the panel body, the locating column may extend downwards from a bottom surface of the panel body, and a guidance chamfer may be arranged at a bottom end of the locating column. A locating hole mated with the locating column may be provided on the chassis having the sheet metal body.

In an exemplary embodiment, the chassis connecting components may be connecting orifices.

In an exemplary embodiment, the connecting orifices may be kidney-shaped orifices, wherein the kidney-shaped orifices extend in a length direction of the panel body.

In an exemplary embodiment, a guidance chamfer may be arranged on side wall of each kidney-shaped orifice.

In an exemplary embodiment, a groove for accommodating a film may be provided on a top surface of the panel body.

In an exemplary embodiment, outer surfaces of the pair of clamping boards may be circular arc surfaces.

The beneficial effects of the embodiments of the present disclosure are described in detail as follows.

By means of the embodiments of the present disclosure, the locating column and the elastic connecting components are arranged on the panel, and the locating hole to be connected to the locating column and the kidney-shaped orifices to be connected to the elastic connecting components are provided on the chassis having the sheet metal body. When the panel and the chassis having the sheet metal body are assembled, a deformation direction of the panel can be halved by middle location, thereby reducing the deformation of a single direction by half. The kidney-shaped orifices in the chassis having the sheet metal body provide the panel with a sufficient stretching space after deformation, thereby keeping surface fit between the panel and the chassis having the sheet metal body all the time. The entire assembly efficiency and the mounting reliability are improved, the panel is applicable to both high-temperature and low-temperature application scenarios, the effect of sharing a model by multiple objects is achieved, and the cost is reduced.

### Brief Description of the Drawings

Fig. 1 is a schematic diagram of panel assembly according to an embodiment of the present disclosure;
Fig. 2 is a schematic diagram of a bottom surface of a panel according to an embodiment of the present disclosure;
Fig. 3 is an enlarged view of a part A in Fig. 2; and
Fig. 4 is a part sectioned view in a width direction of a panel.

Drawing mark descriptions: 1: chassis having a sheet metal body; 10: connecting orifice; 2: panel; 20: panel body; 21, 21a, 21 b: through hole; 22: base; 23, 24: clamping board; 23a, 24a: flange; 25: locating column; 26: groove; and 3: film.

### Detailed Description of the Embodiments

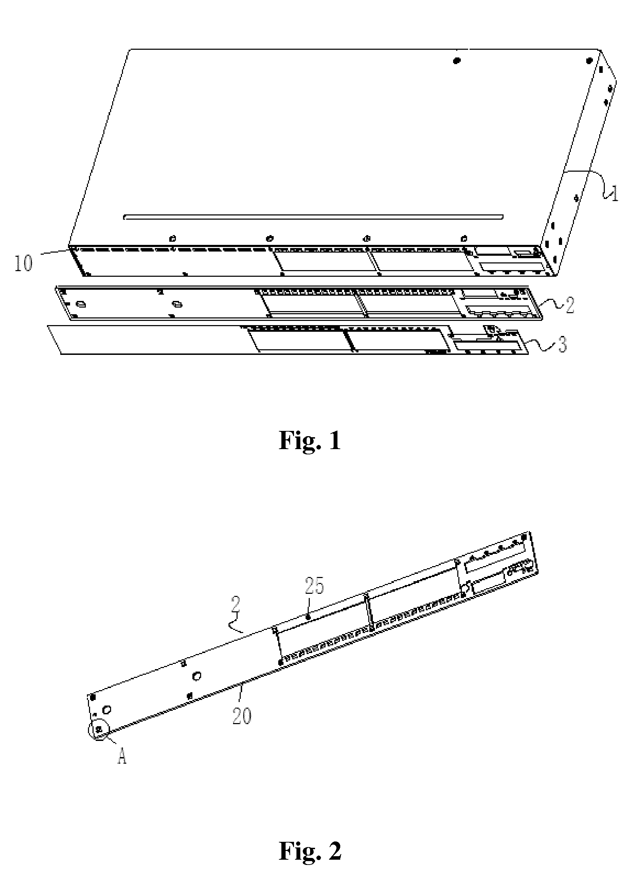

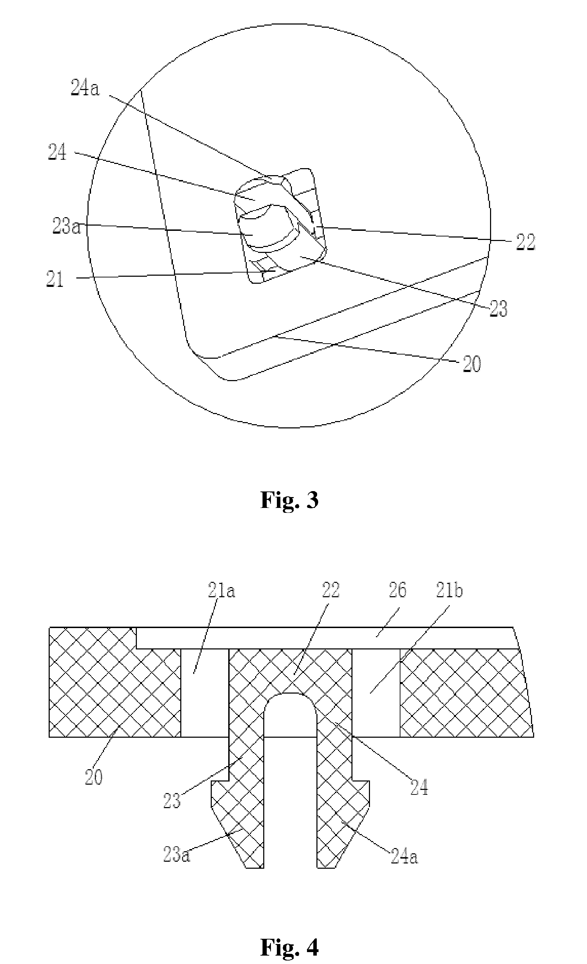

Fig. 1 is a schematic diagram of panel assembly according to an embodiment of the present disclosure. Fig. 2 is a schematic diagram of a bottom surface of a panel according to an embodiment of the present disclosure. Fig. 3 is an enlarged view of a part A in Fig. 2. Fig. 4 is a part sectioned view in a width direction of a panel. As shown in Fig. 1, a panel 2 for a chassis 1 having a sheet metal body according to an embodiment of the present disclosure includes: a panel body 20, mated with a chassis 1 having a sheet metal body; elastic connecting components, mounted on the panel body; and chassis connecting components, arranged on the chassis 1 having the sheet metal body and mated with the elastic connecting components. The panel 2 and the chassis 1 having the sheet metal body can be assembled by connecting the elastic connecting components with the chassis connecting components, thereby realizing quick assembly. During disassembly, the panel and the chassis 1 having the sheet metal body can be separated by disconnecting the elastic connecting components from the chassis connecting components.

In an exemplary embodiment, as shown in Fig. 2, Fig. 3 and Fig. 4, there are multiple elastic connecting components according to the embodiment of the present disclosure. The multiple elastic connecting components are symmetrically disposed along two edges of the panel body 20. Each elastic connecting component may include: a through hole 21, provided on the panel body 20; a base 22, extending in a length direction of the panel body 20 and arranged in the through hole 21, and dividing the through hole 21 into two isolated parts 21 a, 21 b (as shown in Fig. 4) which are disposed in a width direction of the panel body; and a pair of clamping boards 23, 24, arranged on the base 22 and disposed in the width direction of the panel body, wherein the pair of clamping boards 23 and 24 extends downwards out of a bottom surface of the panel body 20 from a bottom surface of the base 22, and outer walls of bottom ends of the pair of clamping boards 23 and 24 are provided with flanges 23a, 24a (as shown in Fig. 3 and Fig. 4). Outer surfaces of the pair of clamping boards 23 and 24 according to the embodiment of the present disclosure are circular arc surfaces. As shown in Fig. 3 and Fig. 4, outer surfaces of the pair of clamping boards 23 and 24 are cylindrical surfaces. A thickness of the base 22 is smaller than a thickness of the panel body 20, so that the pair of clamping boards 23 and 24 is elastic enough.

The chassis connecting components according to the embodiment of the present disclosure may be connecting orifices 10. Multiple connecting orifices 10 are correspondingly provided on the chassis 1 having the sheet metal body and are in one-to-one correspondence to the elastic connecting components. The connecting orifices 10 according to the embodiment of the present disclosure may be kidney-shaped orifices, wherein the kidney-shaped orifices extend in a length direction of the panel body 20. A guidance chamfer is arranged on each kidney-shaped orifice.

Also as shown in Fig. 2, a locating column 25 is arranged in the middle of the panel body, the locating column 25 extends downwards from a bottom surface of the panel body 20, and a guidance chamfer is arranged at a bottom end of the locating column 25. A locating hole (not shown in Figure) mated with the locating column is provided on the chassis 1 having the sheet metal body. When the panel and the chassis 1 having the sheet metal body are assembled, the locating column 25 is inserted into the locating hole, so that the multiple elastic connecting components and the multiple connecting orifices 10 are in one-to-one correspondence; then, the elastic connecting components are pressed tightly in sequence from the middle to the left and right sides, so that the pair of clamping boards of each elastic connecting component is clamped into the corresponding connecting orifice 10, a housing of the chassis 1 having the sheet metal body is clamped between top end surfaces of the flanges 23a, 24a and the bottom surface of the panel body 20 as shown in Fig. 4, and the panel 2 can be connected to the chassis 1 having the sheet metal body in a clamping manner, and in this way, the panel 2 and the chassis 1 having the sheet metal body can be quickly assembled. During disassembly, the panel 2 can be removed from the chassis 1 having the sheet metal body by forcibly pulling the pair of clamping boards of each elastic connecting component out of the corresponding connecting orifice 10,.

In such a way, the problem of high temperature deformation of the panel can be solved in two aspects. Firstly, middle location is performed to halve a deformation direction of the panel, thereby reducing the deformation of a single direction by half. Secondly, the kidney-shaped orifices in the chassis 1 having the sheet metal body provide the panel with a sufficient stretching space after deformation, thereby keeping surface fit between the panel and the chassis 1 having the sheet metal body all the time, and avoiding the phenomenon of warping.

As shown in Fig. 4, a groove 26 for accommodating a film 3 may be provided on a top surface of the panel body 20 according to the embodiment of the present disclosure. A bottom surface of the groove 26 is flush with the top surface of the base 22.

Although the embodiments of the present disclosure is described above in detail, the present disclosure is not limited thereto, and those skilled in the art can make modifications according to the principle of the embodiments of the present disclosure. Thus, various modifications made according to the principle of the embodiments of the present disclosure shall be interpreted as falling within the protection scope of the present disclosure.

### Industrial Applicability

The technical solutions provided by the embodiments of the present disclosure can be applied to the field of communication devices, the entire assembly efficiency and the mounting reliability are improved, the panel is applicable to both high-temperature and low-temperature application scenarios, the effect of sharing a model by multiple objects is achieved, and the cost is reduced.

## Claims

1. A panel for a chassis having a sheet metal body, the panel comprising:
a panel body (20), mated with a chassis having a sheet metal body;
elastic connecting components, mounted on the panel body (20); and
chassis connecting components, arranged on the chassis having the sheet metal body and mated with the elastic connecting components.

2. The panel as claimed in claim 1, wherein each elastic connecting component comprises:
a through hole (21), provided on the panel body (20);
a base (22), extending in a length direction of the panel body (20), arranged in the through hole (21), and dividing the through hole (21) into two isolated parts which are disposed in a width direction of the plastic panel body (20); and
a pair of clamping boards (23, 24), arranged on the base (22) and disposed in the width direction of the panel body (20), wherein the pair of clamping boards (23, 24) extends downwards out of a bottom surface of the panel body (20) from a bottom surface of the base, and outer walls of bottom ends of the pair of clamping boards (23, 24) are provided with flanges (23a, 24a).

3. The panel as claimed in claim 2, wherein a thickness of the base (22) is smaller than a thickness of the panel body (20).

4. The panel as claimed in any one of claims 1 to 3, wherein a locating column (25) is arranged in the middle of the panel body (20), the locating column (25) extends downwards from a bottom surface of the panel body (20), and a guidance chamfer is arranged at a bottom end of the locating column (25); and a locating hole mated with the locating column (25) is provided on the chassis having the sheet metal body.

5. The panel as claimed in claim 4, wherein the chassis connecting components are connecting orifices (10).

6. The panel as claimed in claim 5, wherein the connecting orifices (10) are kidney-shaped orifices, wherein the kidney-shaped orifices extend in a length direction of the panel body (20).

7. The panel as claimed in claim 6, wherein a guidance chamfer is arranged on each kidney-shaped orifice.

8. The panel as claimed in claim 7, wherein a groove (26) for accommodating a film (3) is provided on a top surface of the panel body (20).

9. The panel as claimed in claim 2, wherein outer surfaces of the pair of clamping boards (23, 24) are circular arc surfaces.
